# DEMANDE DE BREVET EUROPEEN

(11) **EP 4 826 998 A1**
(43) Date de publication de la demande: **21.10.2026**
(21) Numéro de dépôt: 26171346.5
(22) Date de dépôt: 09.04.2026
(51) Int. Cl.: H03K 17/12, H03K 17/16

(54) **PROCÉDÉ DE PRÉCHARGE POUR UN CIRCUIT DE COMMUTATION À HAUTE TENSION ET DISPOSITIF DE PRÉCHARGE ASSOCIÉ**

(30) Priorité: 14.04.2025 FR 2503948
(71) Demandeur: Safran Electrical & Power, 31702 Blagnac (FR)
(72) Inventeur: GUILLARD, Eric, 77550 Moissy Cramayel (FR); RAVEL, Pierre, 77550 Moissy Cramayel (FR); ROBIN, Yoann, 77550 Moissy Cramayel (FR)
(74) Mandataire: Casalonga

(57) **Abrégé**

La présente invention concerne un procédé de précharge pour un circuit de commutation (2) à haute tension comprenant un contacteur principal (4), unipolaire ou bipolaire, connecté à une source de tension (3), au moins une branche auxiliaire (6) montée en parallèle du contacteur principal (4), comprenant un contacteur auxiliaire (7) et au moins une résistance de limitation (9), ainsi qu'une charge (5) comprenant un élément capacitif connecté en aval du contacteur principal (4).

Le procédé de précharge comprend la réception d'une demande de fermeture du contacteur principal (4), la vérification de son état, puis l'ouverture et la fermeture des contacteurs principal (4) et auxiliaire (7) pour activer ou désactiver une précharge. Celle-ci est maintenue tant que la tension aval (V2) du contacteur principal (4) est inférieure à un seuil de stabilisation (S2) et que la différence de tension (D) entre l'amont (V1) et l'aval (V2) dépasse un seuil prédéfini (S1). Lorsque ces conditions sont satisfaites, le contacteur principal (4) est fermé et la précharge désactivée (E7).

## Description

### Domaine technique

La présente invention concerne, de manière générale, la protection d'une architecture électrique dans le cadre d'une propulsion électrique, ou hybride, d'un aéronef.

Plus précisément, l'invention se rapporte à un procédé de précharge pour un circuit de commutation à haute tension et à un dispositif de précharge associé.

### Techniques antérieures

Les aéronefs à propulsion électrique ou hybride, notamment les aéronefs à décollage et atterrissage vertical (VTOL), ou sur pistes courtes (STOL) ou autres aéronefs conventionnels (CTOL), représentent un marché prometteur pour le transport de personnes et de marchandises au sein des zones urbaines. Par ailleurs, différents acteurs établis du secteur aéronautique contribuent activement au développement de ces technologies.

La demande pour de tels systèmes de propulsion électriques ne cesse donc de croître, portée notamment par des innovations constantes concernant l'architecture et la gestion des systèmes électriques embarqués.

De tels configurations d'aéronefs reposent entre autres sur des systèmes de propulsion composés d'un ou plusieurs moteurs électriques. La configuration des moteurs varie en fonction de l'architecture de l'aéronef, permettant ainsi d'optimiser les performances en fonction des exigences opérationnelles.

Les systèmes électriques de propulsion utilisent des niveaux de tension continue élevés pour alimenter ces moteurs électriques et les convertisseurs. Ces systèmes tirent notamment leur énergie de batteries haute tension ou de générateurs HVDC, qui sont connectés aux charges via des contacteurs électromécaniques, formant alors un circuit de commutation à haute tension.

Les convertisseurs peuvent nécessiter l'intégration de condensateurs en amont de l'électronique de puissance, ces derniers favorisant un bon fonctionnement d'un tel circuit.

La fermeture des contacteurs de puissance peut générer des courants impulsionnels élevés, notamment lors de la charge initiale des condensateurs, créant ainsi des transitoires dangereux pour le système. Un condensateur non chargé ou partiellement chargé se comporte comme un court-circuit, ce qui entraîne un flux de courant important lors de la mise sous tension. Ces courants transitoires sont problématiques car ils peuvent provoquer la soudure des contacts dans les commutateurs mécaniques, compromettant ainsi la sécurité du système et empêchant une déconnexion sûre.

Une solution couramment utilisée pour minimiser les courants impulsionnels est l'implémentation d'un circuit auxiliaire de précharge. Ce circuit auxiliaire utilise un contacteur auxiliaire équipé d'une résistance de limitation de courant ou d'un système de régulation de courant pour charger progressivement les condensateurs. Ainsi, lorsque le contacteur principal se ferme, la tension de la source et de la charge étant équivalentes ou proches, les courants transitoires sont évités.

Dans certaines configurations, plusieurs sources de tension HVDC peuvent être commutées, ce qui nécessite une reconfiguration du réseau électrique, entraînant des déconnexions temporaires pouvant durer plusieurs centaines de millisecondes. Durant ces interruptions, les condensateurs continuent à alimenter les charges, mais la tension chute rapidement. Avant de reconnecter une source à la charge, une nouvelle phase de précharge est nécessaire pour éviter les pics de courant transitoires.

Actuellement, la gestion des contacteurs de circuits de commutation à haute tension est le plus souvent réalisée par des systèmes centralisés qui surveillent l'état du réseau électrique. Ainsi, lorsque la tension de la charge revient à zéro volts ou lorsqu'une séquence d'ouverture des contacteurs de source est détectée, une série de commandes est exécutée pour assurer une mise sous tension progressive. Ces systèmes utilisent soit des séquences temporisées, soit des vérifications de tension avant de fermer le contacteur principal, garantissant ainsi une précharge des condensateurs.

Bien que ces approches soient efficaces pour prévenir les courants transitoires dangereux, elles présentent plusieurs inconvénients.

D'une part, elles nécessitent l'utilisation d'un grand nombre de signaux et de ressources dédiées pour surveiller et contrôler les contacteurs. De plus, la complexité des séquences de temporisation et de vérification rend l'architecture de gestion lourde et sujette à des erreurs de synchronisation ou à des dysfonctionnements potentiels.

Il existe donc un besoin d'une solution simplifiée et moins gourmande en ressources pour la gestion des contacteurs dans de tels circuits de commutation à haute tension.

### Exposé de l'invention

La présente invention vise donc à pallier tout ou partie des inconvénients précités et a pour but de proposer un circuit de commutation à haute tension autonome ayant une gestion de précharge autonome.

Pour ce faire, l'invention a pour objet un procédé de précharge pour un circuit de commutation à haute tension.

Le circuit de commutation à haute tension comprend au moins un contacteur principal, unipolaire ou bipolaire, connecté à au moins une source de tension, au moins une branche auxiliaire comprenant un contacteur auxiliaire, ladite branche auxiliaire étant montée en parallèle du contacteur principal, chaque pôle du contacteur principal étant associé à une branche auxiliaire, au moins une desdites branches auxiliaires comprenant une résistance de limitation en série avec le contacteur auxiliaire, et au moins une charge comprenant un élément capacitif et connectée en aval du contacteur principal.

Le procédé comprend les étapes suivantes :
- recevoir une demande de fermeture du contacteur principal, ladite demande de fermeture étant maintenue en continu,
- vérifier l'état du contacteur principal,
- commander l'ouverture et la fermeture des contacteurs principal et auxiliaire pour activer ou désactiver une précharge, ladite précharge comprenant l'ouverture du contacteur principal et la fermeture du contacteur auxiliaire pour charger progressivement la charge à travers la résistance de limitation,
- lorsque, à l'étape de vérification, le contacteur principal est ouvert :
   - si la différence de tension entre l'amont et l'aval du contacteur principal est inférieure à un premier seuil prédéfini, fermer le contacteur principal et désactiver la précharge,
   - si la différence de tension est supérieure au premier seuil, maintenir le contacteur principal ouvert et poursuivre la précharge,
   - lorsque, à l'étape de vérification, le contacteur principal est fermé :
      - si la tension aval est supérieure à un deuxième seuil prédéfini, maintenir le contacteur principal fermé et la précharge désactivée,
      - si la tension en aval du contacteur principal est inférieure à un deuxième seuil prédéfini, ouvrir le contacteur principal pour activer la précharge.

Avantageusement, la précharge étant maintenue jusqu'à ce que la tension aval soit supérieure à un troisième seuil prédéfini et que la différence de tension entre l'amont et l'aval du contacteur principal soit inférieure au premier seuil prédéfini, puis le contacteur principal est fermé et le contacteur auxiliaire est ouvert pour désactiver la précharge.

Le procédé de précharge permet une commande dynamique des contacteurs principal et auxiliaire basée sur une comparaison continue des tensions amont et aval du circuit de commutation à des seuils prédéfinis.

De préférence, le premier seuil prédéfini correspond à la différence de tension maximale admissible entre la tension amont et aval du contacteur principal, au-dessus de laquelle, lorsque le contacteur principal est à l'état ouvert, la séquence de précharge est activée.

En outre, le deuxième seuil prédéfini correspond au seuil de stabilisation de la tension aval du contacteur principal, au-dessus de laquelle, lorsque le contacteur principal 4 est ouvert, la précharge est désactivée.

Et le troisième seuil prédéfini correspond à la tension nominale de fonctionnement de la charge, au-dessus de laquelle la différence de tension entre l'amont et l'aval du contacteur principal est comparée au premier seuil prédéfini pour maintenir ou désactiver la précharge.

Dans une variante de mise en œuvre du procédé, la précharge correspond à une précharge électronique réalisée par des composants électroniques configurés pour limiter le courant dans le circuit de commutation.

Selon un autre aspect de l'invention, le circuit de commutation comprend un contacteur principal bipolaire et ledit procédé de précharge comprend en outre les étapes suivantes :
- commander l'ouverture et la fermeture du contacteur principal bipolaire de manière synchrone,
- réaliser la précharge sur le ou les pôles du contacteur principal associés à une branche auxiliaire comprenant une résistance de limitation.

Un autre objet de l'invention concerne un dispositif de précharge dans un circuit de commutation à haute tension comprenant un contacteur principal, unipolaire ou bipolaire, connecté à au moins une source de tension, au moins une branche auxiliaire comprenant un contacteur auxiliaire, ladite branche auxiliaire étant montée en parallèle du contacteur principal, chaque pôle du contacteur principal étant associé à une branche auxiliaire, au moins une desdites branches auxiliaires comprenant une résistance de limitation en série avec le contacteur auxiliaire, et au moins une charge comprenant un élément capacitif et connectée en aval du contacteur principal.

Le dispositif de précharge comprend :
- un module de gestion de la précharge, comprenant au moins une unité de traitement configurée pour mettre en œuvre les étapes du procédé de précharge telles que défini précédemment,
- un module de mesure de tension, configuré pour mesurer localement les tensions en amont et en aval du contacteur principal et transmettre les valeurs mesurées au module de comparaison,
- un module de comparaison, configuré pour comparer la différence de tension entre l'amont et l'aval du contacteur principal avec des seuils de tension prédéfinis, et pour transmettre le résultat à un module de commande,
- un module de commande, configuré pour recevoir les données issues du module de comparaison et pour commander l'ouverture ou la fermeture des contacteurs principal et auxiliaire en fonction des seuils de tension prédéfinis, afin d'activer ou de désactiver une précharge.

Par ailleurs, le module de gestion de la précharge peut être configuré pour exécuter une précharge électronique réalisée par des composants électroniques configurés pour limiter le courant.

La présente invention a aussi pour objet un aéronef comprenant un dispositif de précharge dans un circuit de commutation à haute tension, tel que défini précédemment.

### Brève description des dessins

D'autres buts, avantages et caractéristiques ressortiront de la description détaillée ci-dessous, donnée à titre purement illustratif et faite en référence aux dessins annexés sur lesquels :
- la [Fig 1] illustre un aéronef intégrant un circuit de commutation à haute tension selon l'invention ;
- la [Fig 2] représente un schéma du circuit de commutation à haute tension selon l'invention, montrant un mode de réalisation où le contacteur principal est unipolaire ;
- la [Fig 3] représente un schéma du circuit de commutation à haute tension selon l'invention, avec un contacteur principal bipolaire, chaque pôle étant associé à une branche auxiliaire comprenant une résistance de limitation en série avec un contacteur auxiliaire ;
- la [Fig 4] représente un schéma du circuit de commutation à haute tension selon l'invention, avec un contacteur principal bipolaire, et une seule branche auxiliaire comprenant une résistance de limitation en série avec un contacteur auxiliaire ;
- la [Fig 5] est une illustration des différents modules du dispositif de précharge selon l'invention ; et
- la [Fig 6] présente un schéma fonctionnel des étapes du procédé de précharge selon l'invention.

### DESCRIPTION DETAILLEE

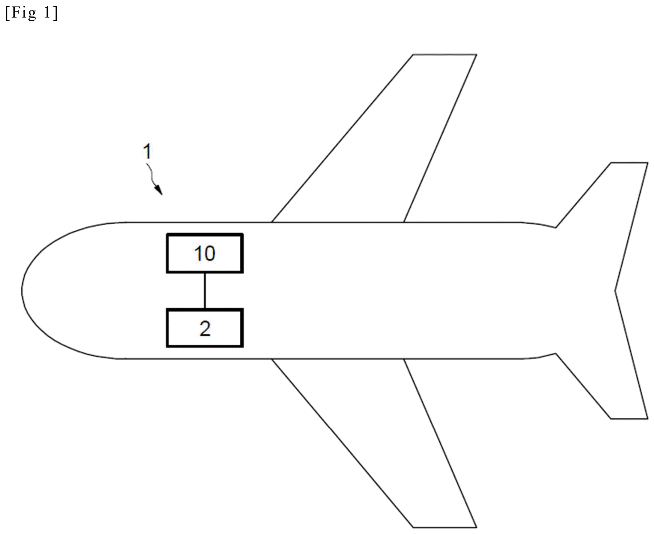

On a représenté sur la figure 1 un aéronef à propulsion électrique ou hybride conforme à l'invention, désigné par la référence numérique générale 1.

L'aéronef 1 comprend notamment un système de propulsion électrique ou hybride dans lequel la propulsion est assurée soit par un ou plusieurs moteurs électriques alimentés par des sources d'énergie à haute tension, soit par une combinaison de moteurs électriques et de moteurs thermiques, permettant une fourniture d'énergie auxiliaire ou principale pour les moteurs électriques en fonction des phases de vol.

Le système de propulsion est alimenté par un système de distribution électrique destiné à acheminer l'énergie électrique depuis une ou des sources d'alimentation vers les moteurs électriques et autres systèmes de bord de l'aéronef.

Le système de distribution est conçu pour gérer des niveaux de haute tension et inclut des dispositifs de régulation et de protection contre les surtensions, assurant ainsi une distribution continue et stable de l'énergie aux composants critiques.

Les moteurs de l'aéronef peuvent être des moteurs synchrones ou asynchrones, selon la conception spécifique de l'aéronef, et sont dimensionnés pour fournir une puissance suffisante pour le décollage, le vol et l'atterrissage.

Ces moteurs sont généralement alimentés par des batteries qui peuvent constituer des de sources d'énergie principales ou auxiliaires et capables de stocker de grandes quantités d'énergie pour alimenter les moteurs électriques, en particulier lors des phases de vol nécessitant une puissance modérée ou pour assurer une autonomie complète en mode électrique.

Dans un système hybride, les batteries peuvent être rechargées en vol par un générateur entrainé par les moteurs thermiques pour produire de l'énergie électrique en continu ou en fonction des besoins en puissance. Ces générateurs permettent de recharger les batteries en vol et de fournir une alimentation directe aux moteurs électriques, réduisant ainsi la consommation de la batterie et optimisant l'autonomie de l'aéronef.

L'aéronef est en outre équipé de sources de tension HVDC (Haute Tension Courant Continu), telles que des batteries haute tension, permettant de stocker et de fournir une alimentation en courant continu à haute tension aux moteurs et autres composants nécessitant une puissance élevée. Ces sources HVDC sont également équipées de dispositifs de conversion pour adapter le niveau de tension selon les besoins du système de propulsion et des autres systèmes électriques de l'aéronef

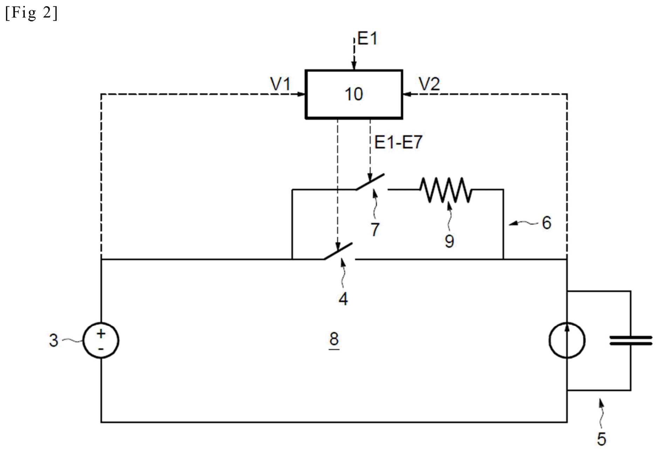

Sur la figure 2, il est représenté un circuit de commutation à haute tension continue, désigné par la référence numérique générale 2, dans une configuration mettant en œuvre un contacteur unipolaire.

Ce circuit 2 assure la gestion et la distribution de l'énergie électrique entre les différentes sources de tension 3, ainsi que la transition entre ces sources selon les contraintes de vol, permettant par exemple une alimentation ininterrompue des moteurs électriques.

Le circuit de commutation 2 peut être adapté pour des moteurs d'aéronefs autres que ceux d'avions.

Le circuit de commutation 2 comprend une source de tension 3 à haute tension connectée en amont du contacteur principal 4, ici unipolaire, et une charge capacitive 5 connectée en aval du contacteur principal 4.

Une branche auxiliaire 6 est connectée en parallèle du contacteur principal 4 et comprend le contacteur auxiliaire 7 et la résistance de limitation 9 en série.

Ces éléments sont disposés sur une branche principale 8, chargée de commuter la tension entre la source de tension 3 et la charge 5.

Les contacteurs principal 4 et auxiliaire 7 sont commandés de manière synchrone et opposée : l'un est fermé lorsque l'autre est ouvert.

Le circuit de commutation 2 est conçu pour fonctionner avec une source de tension 3 unique vue du contacteur principal 4, même si cette source est issue d'un réseau plus complexe en amont. En d'autres termes, le contacteur principal perçoit une seule source de tension 3, qui peut être le résultat d'une combinaison ou d'une sélection de plusieurs sources en amont. Cette approche simplifie la gestion de la précharge, qui sera détaillé dans la suite de description, en se concentrant uniquement sur la tension de la source unique, ce qui permet une grande flexibilité et une adaptation facile à différents types de sources et de réseaux.

La branche auxiliaire 6 du circuit 2 permet notamment d'éviter les courants excessifs susceptibles d'endommager les composants lors de la montée en tension du circuit 2.

Le circuit de commutation 2 peut comporter une ou plusieurs charges capacitives 5. La charge capacitive 5 peut comporter un condensateur d'entrée de forte capacité, nécessitant d'être chargé avant que la charge 5 puisse fonctionner correctement. Dans ce cas, une connexion directe de la source de tension 3 à la charge 5, sans précharge, entraînerait un courant d'appel important qui pourrait endommager les composants du circuit 2, tels que les contacteurs 4,7, les câbles et l'électronique de puissance de la charge 5.

La charge 5 peut inclure des moteurs électriques utilisés pour la propulsion des aéronefs, des convertisseurs de puissance avec un élément capacitif en amont de l'électronique de puissance, des onduleurs, ou des systèmes avioniques qui nécessitent une alimentation haute tension stable.

La résistance de limitation 9 de la branche auxiliaire 6 permet de charger le condensateur de la charge capacitive 5 progressivement en évitant les pics de courant et les variations brusques de tension qui pourraient perturber le fonctionnement du circuit 2 ou endommager la charge 5.

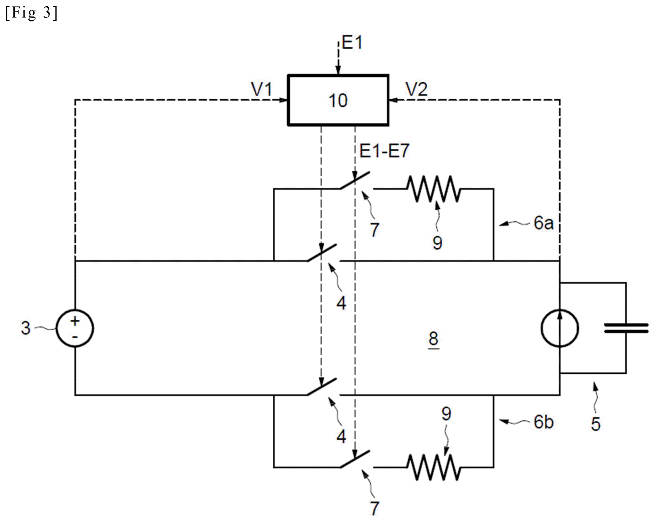

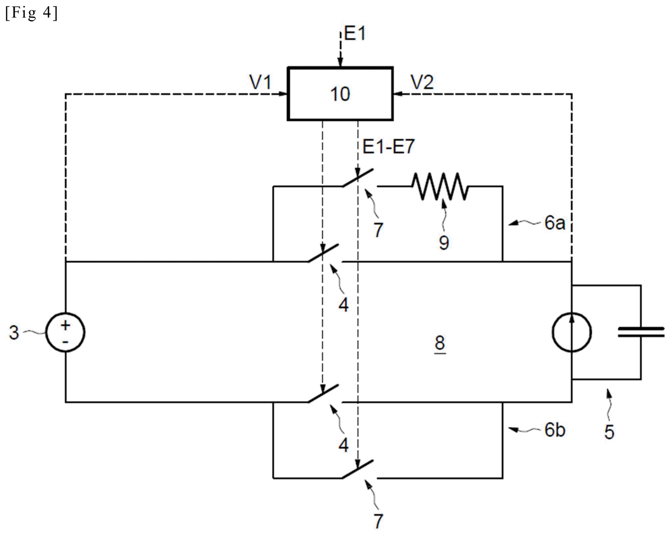

Le circuit de commutation 2 peut être adapté en fonction des besoins. Par exemple, le contacteur principal 4 peut être un contacteur bipolaire tel qu'illustré dans les modes de réalisation présentées aux figures figure 3 et 4.

Les figures 3 et 4 illustrent le circuit de commutation 2 dans une configuration bipolaire, où chaque pôle du contacteur principal 4 est associé à une branche auxiliaire 6a,6b montée en parallèle du contacteur principal 4.

Dans la figure 3, chaque branche auxiliaire 6a,6b comprend un contacteur auxiliaire 7 ainsi qu'une résistance de limitation 9 en série.

Cette disposition permet de maintenir la tension équilibrée entre les deux pôles et d'assurer une redondance sur la résistance de limitation 9.

En effet, si l'une des résistances de limitation 9 venait à se mettre en court-circuit sur l'une des deux branches auxiliaires 6a,6b, l'autre résistance de limitation 9 permettrait toujours de limiter le courant de précharge, garantissant ainsi un fonctionnement sécurisé du circuit de commutation 2.

Sur la figure 4, une seule branche auxiliaire 6a comporte une résistance de limitation 9, tandis que la seconde branche auxiliaire 6b ne contient qu'un contacteur auxiliaire 7 sans résistance en série.

Cette configuration permet notamment de simplifier l'architecture du circuit de commutation tout en conservant une fonction de précharge sur un des pôles du contacteur principal de manière à limiter le courant au niveau de la charge capacitive 5.

Dans les configurations illustrées aux figures 3 et 4, la logique de précharge est la même que celle décrite dans le procédé de précharge appliqué à un circuit de commutation comprenant un contacteur unipolaire, et les étapes de commande des contacteurs principal et auxiliaire sont synchronisées pour garantir une mise sous tension en douceur de la charge.

Dans un mode de réalisation non illustré, la branche auxiliaire 6 du circuit de commutation 2 peut comporter un dispositif de précharge électronique 10 relié au circuit de commutation 2 en parallèle avec le contacteur principal 4, connecté aux nœuds amont et aval dudit contacteur 4.

Dans un tel mode de réalisation, la branche auxiliaire peut comprendre, par exemple, un convertisseur électronique régulant le courant de charge.

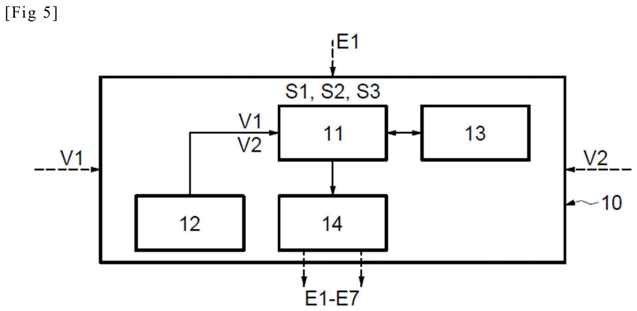

En référence à la figure 5, le circuit de commutation 2 est également connecté à un dispositif de précharge 10.

Le dispositif de précharge 10 est conçu pour protéger les circuits à haute puissance contre les courants d'appel lors de la mise sous tension du circuit de commutation 2 et pour gérer efficacement la transition entre différentes sources de tension 3.

Le dispositif de précharge 10 comprend plusieurs modules interconnectés qui assurent la gestion de la précharge, la surveillance en temps réel des tensions en amont V1 et en aval V2 du contacteur principal 4, ainsi que la commande des contacteurs 4,5 pour activer ou désactiver la précharge selon les conditions du circuit 2.

Le dispositif de précharge 10 comprend un module de gestion de la précharge 11 piloté par une unité de traitement programmée pour gérer automatiquement une précharge.

L'unité de traitement peut inclure un calculateur, un microcontrôleur ou encore un microprocesseur et, en outre, des interfaces de communication pour échanger des informations aux autres modules du dispositif de précharge 10.

L'unité de traitement du module de gestion de précharge 11 commande en temps réel l'activation ou la désactivation des contacteurs 4,7 en fonction des signaux reçus.

En outre, l'unité de traitement comprend une mémoire dans laquelle sont stockées les demandes de fermeture du contacteur principal, les séquences d'ouverture et de fermeture des contacteurs principal 4 et auxiliaire 7, ainsi que les paramètres opérationnels prévus pour être utilisées lors des comparaisons et des commandes des contacteurs principal 4 et auxiliaire 7.

Le module de gestion 11 dispose, par exemple, d'entrées dédiées, dont l'une est prévue pour recevoir la demande de fermeture du contacteur principal 4, destinée à être transmise au circuit de commutation 2. Le module 11 est capable de coordonner les autres modules du dispositif de précharge 10 en surveillant les mesures de tension en amont V1 et en aval V2 du contacteur principal 4, en analysant la différence de tension pour déterminer l'ouverture et la fermeture des contacteurs principal 4 et auxiliaire 7 et déterminer par conséquent si une précharge est nécessaire, garantissant ainsi un fonctionnement autonome du dispositif de précharge 10.

Le dispositif de précharge 10 comporte également un module de mesure de tension 12, prévu pour surveiller les tensions en amont V1 et en aval V2 du contacteur principal 4.

Le module de mesure de tension 12 est situé en amont (côté source) et en aval (côté charge) du contacteur principal 4 de la branche principale 8 du circuit de commutation 2.

Le module de tension 12 peut également comprendre des capteurs de tension positionnés en amont et en aval du contacteur principal 4. Il comprend un capteur de tension placé avant le contacteur principal 4, entre la source de tension 3 et le contacteur principal 4 mesurant la tension V1 directement fournie par la source de haute tension 3 et un capteur de tension placé après le contacteur principal 4, du côté charge 5, entre le contacteur principal 4 et la charge capacitive 5 afin de mesurer la tension en aval V2 du contacteur principal 4.

Par exemple, dans le cas où le contacteur principal 4 est ouvert, et que le contacteur auxiliaire 7 est fermé, le courant circule alors dans la branche auxiliaire 6 du circuit de commutation 2. La résistance de limitation 9 de la branche auxiliaire 6 permet de limiter le courant et de charger progressivement le condensateur de la charge 5. On est alors dans une phase de précharge, qui prépare la charge 5 à être connectée directement à la source de tension 3.

Dans ce cas, les capteurs de tension surveillent la tension d'entrée afin de vérifier que la source de tension 3 est stable et prête à alimenter la charge 5 en se stabilisant lors de la précharge afin d'évaluer quand le contacteur principal 4 peut être fermé.

De plus, la mesure de la tension en aval V2 du contacteur principal 4 permet de s'assurer que la différence D de tension avec l'amont V1 est suffisamment réduite avant de fermer le contacteur principal 4, évitant ainsi un courant d'appel excessif.

Le dispositif de précharge 10 comprend également un module de comparaison 13 configuré pour comparer les tensions V1,V2 mesurées à des valeurs de seuils prédéfinis S1, S2, S3 et pour évaluer la différence D de tension V1, V2 entre l'amont et l'aval du contacteur principal 4.

Les seuils S1, S2 et S3 sont des valeurs de tension critiques qui permettent de contrôler l'ouverture et la fermeture des contacteurs principal 4 et auxiliaire 7, de déclencher et de terminer la séquence de précharge, et de protéger la charge 7 contre les situations anormales. Leurs valeurs sont choisies en fonction des caractéristiques du circuit 2 et des besoins de la charge 7.

En particulier, le premier seuil prédéfini S1 représente la différence de tension maximale admissible entre la tension amont V1 et la tension aval V2 du contacteur principal 4 lorsque celui-ci est ouvert.

Si la différence de tension D mesurée est inférieure à ce seuil S1, le contacteur principal 4 peut être fermé directement sans risquer de générer un courant d'appel excessif.

Si la différence de tension D est supérieure à ce seuil S1, la séquence de précharge est activée pour charger progressivement le condensateur de la charge.

Par exemple, le premier seuil S1 peut être de l'ordre de l'ordre d'une dizaine de volts.

Le deuxième seuil prédéfini S2 correspond au seuil de stabilisation de la tension aval V2 , au-dessus duquel la précharge est désactivée.

De ce fait, lorsque la tension mesurée en aval V2 du contacteur principal est inférieure au seuil S2 de stabilisation de la tension aval V2, cela indique que la tension en aval V2 du contacteur principal 4 n'est pas encore stabilisée, ce qui peut résulter d'une perte de la source de tension ou d'une surcharge.

Dans ce cas, le contacteur principal 4 est ouvert pour protéger la charge, et la séquence de précharge est activée afin d'élever progressivement la tension en aval V2 et de permettre une reconfiguration des sources si nécessaire.

Par reconfiguration des sources, on entend la modification de la source d'alimentation du circuit de commutation pour assurer la continuité de l'alimentation de la charge capacitive en cas de panne, de perte, ou pour optimiser les performances à la suite d'une situation anormale d'une première source de tension.

Le troisième seuil prédéfini S3 correspond à la tension nominale de fonctionnement de la charge.

Lors de la séquence de précharge, le contacteur principal 4 est maintenu ouvert et le contacteur auxiliaire 7 est fermé jusqu'à ce que la tension en aval V2 atteigne le troisième seuil S3.

Une fois la tension nominale atteinte, le dispositif de précharge vérifie si la différence de tension D entre l'amont V1 et l'aval V2 du contacteur principal 4 est inférieure au premier seuil S1. Si cette condition est remplie, la séquence de précharge est terminée et le contacteur principal 4 est fermé.

Dans le cas contraire, la précharge est maintenue jusqu'à ce que cette condition soit satisfaite.

Le module de comparaison 13 peut également comprendre des convertisseurs analogiques-numériques convertissant les tensions analogiques mesurées en signaux numériques exploitables par l'unité de traitement du module de gestion de la précharge 11, ou éventuellement à des amplificateurs opérationnels configurés en mode comparateur pour fournir une sortie basée sur la différence entre les tensions amont et aval.

Le dispositif de précharge 10 comprend par ailleurs un module de commande 14 qui reçoit des signaux de commande du module de gestion de la précharge 11 et pilote les contacteurs principal et auxiliaire. Ces signaux correspondent à l'application d'une commande d'ouverture ou de fermeture des contacteurs principal et auxiliaire.

La commande des contacteurs principal 4 et auxiliaire 7 est réalisée en fonction de la différence de tension D mesuré en amont V1 et en aval V2 du contacteur principal 4 et de la tension en aval V2 dudit contacteur principal 4.

Le premier seuil prédéfini S1 est appliqué à la différence de tension D, tandis que les deuxième S2 et troisième S3 seuils prédéfinis sont appliqués à la tension aval V2. Cette gestion des seuils permet un contrôle itératif et dynamique de la précharge, en adaptant les actions de commande du contacteur principal 4 à ces valeurs de tensions.

Avantageusement, le dispositif de précharge 10 permet d'offrir une stabilité accrue du réseau face à des niveaux de tension élevés et une protection efficace contre les pics de courant qui peuvent survenir lors de la mise sous tension ou en cas de fluctuations soudaines de la demande énergétique.

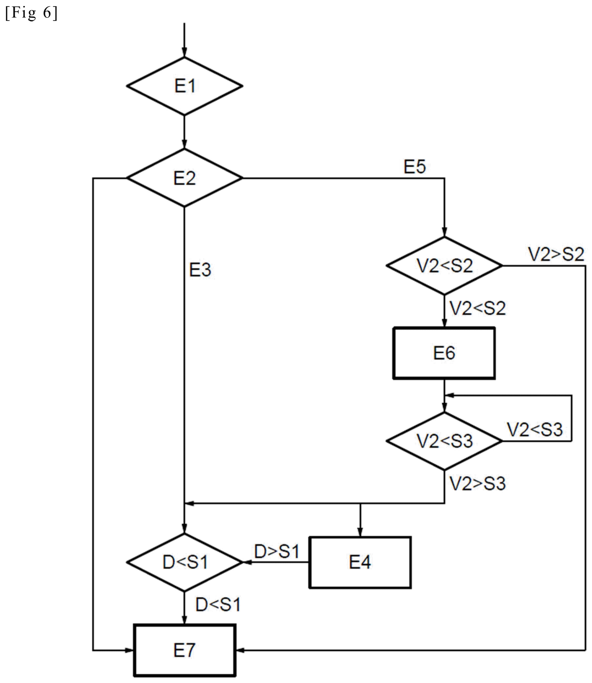

On va maintenant décrire en référence à la figure 6 le procédé de précharge mis en œuvre au moyen du dispositif de précharge 10 qui vient d'être décrit.

Ce procédé gère la précharge de la charge capacitive 7 dans le circuit de commutation 2 à haute tension en surveillant en continu l'état du contacteur principal 4 et les tensions en amont V1 et en aval V2 de celui-ci, afin de prendre des décisions en temps réel pour assurer une précharge optimale et sécurisée.

Le dispositif de précharge 10 commence par recevoir une demande de fermeture E1 du contacteur principal 4. Cette demande de fermeture E1 est maintenue en continu, ce qui signifie qu'elle est conservée en mémoire dans l'unité de traitement du dispositif de précharge 10 et reste active même si le contacteur principal 4 n'est pas fermé immédiatement. Cela permet de gérer les situations où la précharge est nécessaire avant la fermeture du contacteur principal 4.

Le dispositif de précharge 10 vérifie E2 ensuite l'état du contacteur principal 4, c'est-à-dire s'il est ouvert ou fermé. Cette vérification E2 est effectuée à chaque demande de fermeture E1, ce qui permet de prendre en compte l'état initial du contacteur principal 4 dans le déroulement des étapes du procédé de précharge.

Puis, on commande l'ouverture et la fermeture du contacteur principal 4 pour activer ou désactiver la précharge.

Les contacteurs principal 4 et auxiliaire 7 sont commandés de manière synchrone et opposée : l'un est fermé lorsque l'autre est ouvert.

La précharge est activée en ouvrant le contacteur principal 4 et en fermant le contacteur auxiliaire 7. Cela permet de charger progressivement la charge 7 à travers la résistance de limitation 9, limitant ainsi le courant d'appel.

La précharge est désactivée en fermant le contacteur principal 4 et en ouvrant le contacteur auxiliaire 7. La charge 5 est alors connectée directement à la source de tension 3.

Lors d'une demande de fermeture E2 du contacteur principal 4, la différence de tension D entre la tension en amont V1 du contacteur principal 4 et la tension en aval V2 du contacteur principal 4 est mesurée.

Si cette différence de tension D est supérieure au seuil de différence de tension maximale S1, cela indique que la tension en aval V2 du contacteur principal 4, donc aux bornes de la charge capacitive 5, est significativement différente de la tension de la source de tension 3.

Dans ce cas, une précharge est activée E4 afin de charger progressivement la charge capacitive 5 à travers la résistance de limitation 9, limitant ainsi le courant d'appel qui se produirait si le contacteur principal 4 était fermé directement, ce qui pourrait endommager les composants du circuit 2.

Lorsque le contacteur principal 4 est fermé E5, la tension en aval V2 du contacteur principal 4 est surveillée.

Si la tension en aval V2 du contacteur principal 4 est inférieure au seuil de stabilisation de la tension aval S2, cela indique que la tension en aval V2 du contacteur principal 4 est insuffisante pour garantir un fonctionnement normal, ce qui peut résulter d'une perte de la source de tension 3 ou d'une surcharge.

Dans ce cas, le contacteur principal 4 est ouvert afin de protéger la charge capacitive 5, et une précharge est activée E6 pour rétablir progressivement la tension en aval V2 du contacteur principal 4.

La précharge est maintenue tant que la tension en aval V2 du contacteur principal 4 demeure inférieure au seuil de stabilisation de la tension aval S2.

Lorsque la tension en aval V2 est supérieure au seuil prédéfini S2, la tension en aval V2 est considérée comme stabilisée, permettant ainsi la désactivation de la précharge et le maintien du contacteur principal 4 fermé pour assurer une alimentation directe et stable de la charge 5

Cette étape E6 peut notamment intervenir lors d'une phase de reconfiguration des sources d'alimentation, afin de garantir une alimentation continue de la charge capacitive 5, même en cas de panne ou de défaillance de la source de tension 3. Cela contribue à améliorer la sécurité et la fiabilité du système de distribution électrique de l'aéronef 1.

Par exemple, la reconfiguration des sources peut être utilisée pour passer d'une batterie principale à une batterie auxiliaire en cas de panne de la batterie principale. Le procédé de précharge garantit alors une alimentation continue des moteurs électriques pendant la transition entre les batteries.

Cependant, il est tout à fait possible que la tension de la source de tension 3 chute temporairement, puis remonte sans qu'il y ait besoin de changer de source.

Pour revenir à la description des étapes du procédé de précharge, on comprend donc qu'à cette étape du procédé, le contacteur principal 4 est ouvert pour protéger la charge capacitive 5 et qu'une précharge est activée E6 pour limiter le courant d'appel et assurer une montée progressive de la tension en aval V2 du contacteur principal 4.

Une fois la séquence de précharge activée E6, elle est maintenue active jusqu'à ce que la tension en aval V2 du contacteur principal 4 atteigne et dépasse le seuil de stabilisation de la tension aval S2. Lorsque cette condition est remplie, la précharge est désactivée.

Si la tension en aval V2 du contacteur principal 4 continue à augmenter et atteint le seuil de tension nominale de fonctionnement S3, qui correspond à la tension nominale de fonctionnement de la charge capacitive 5, et que la différence de tension D entre la tension en amont V1 du contacteur principal 4 et la tension en aval V2 du contacteur principal 4 devient inférieure au seuil de différence de tension maximale S1, alors le contacteur principal 4 est fermé et le contacteur auxiliaire 7 est ouvert, terminant ainsi la précharge E7 et permettant l'alimentation directe de la charge capacitive 5 par la source de tension 3.

On comprend donc que la condition essentielle pour terminer la précharge E7 est que la différence de tension D entre la tension en amont V1 du contacteur principal 4 et la tension en aval V2 du contacteur principal 4 soit inférieure au seuil de différence de tension maximale S1, même si la tension en aval V2 du contacteur principal 4 a déjà atteint le seuil de tension nominale de fonctionnement S3.

De cette façon, le procédé de précharge garantit que la tension de la charge est suffisamment proche de celle de la source 3 pour éviter un courant d'appel excessif lors de la fermeture du contacteur principal 4.

Ainsi, le procédé de précharge se déroule de manière séquentielle et adaptative, en fonction de l'état du contacteur principal 4 et des tensions mesurées en amont V1 et en aval V2 dudit contacteur 4.

Le procédé de précharge permet notamment de gérer les situations où la précharge est nécessaire avant la fermeture du contacteur principal 4, grâce au maintien continu de la demande de fermeture.

Alternativement, dans un autre mode de réalisation (non illustré), le procédé peut être optimisé par l'utilisation de composants électroniques pour moduler dynamiquement le courant. Ce type de précharge électronique permet un contrôle précis de la montée en tension, ajustant automatiquement la résistance en fonction des conditions spécifiques du circuit 2 et des écarts de tension mesurés.

La modulation électronique du courant peut contribuer à améliorer l'efficacité du système en réduisant les pertes d'énergie, et permettre une gestion précise des variations de tension en amont V1 et en aval V2 du contacteur principal 4, en optimisant le temps de précharge à courant constant ou résistance variable.

## Revendications

1. Procédé de précharge pour un circuit de commutation (2) à haute tension, ledit circuit (2) comprenant un contacteur principal (4), unipolaire ou bipolaire, connecté à au moins une source de tension (3),
au moins une branche auxiliaire (6) comprenant un contacteur auxiliaire (7), ladite branche auxiliaire (6) étant montée en parallèle du contacteur principal (4), chaque pôle du contacteur principal (4) étant associé à une branche auxiliaire (6), au moins une desdites branches auxiliaires (6) comprenant une résistance de limitation (9) en série avec le contacteur auxiliaire (7), et au moins une charge (5) comprenant un élément capacitif et connectée en aval du contacteur principal (4),
le procédé de précharge comprenant les étapes suivantes :
- recevoir (E1) une demande de fermeture du contacteur principal (4), ladite demande de fermeture étant maintenue en continu,
- vérifier (E2) l'état du contacteur principal (4),
- commander l'ouverture et la fermeture des contacteurs principal (4) et auxiliaire (7) de manière synchrone et opposée, ladite précharge comprenant l'ouverture du contacteur principal (4) et la fermeture du contacteur auxiliaire (7), pour charger progressivement ladite charge (5) à travers la résistance de limitation (9),
- lorsqu'à l'étape de vérification (E2), le contacteur principal (4) est ouvert (E3) :
- si la différence de tension (D) entre l'amont (V1) et l'aval (V2) du contacteur principal (4) est inférieure à un premier seuil prédéfini (S1), fermer le contacteur principal (4) et désactiver la précharge (E7),
- si la différence de tension (D) est supérieure au premier seuil (S1), maintenir le contacteur principal (4) ouvert et poursuivre la précharge (E4),
- lorsqu'à l'étape de vérification (E2), le contacteur principal (4) est fermé (E5) :
- si la tension aval (V2) est supérieure à un deuxième seuil (S2) prédéfini, maintenir le contacteur principal (4) fermé et la précharge désactivée,
- si la tension en aval (V2) du contacteur principal (4) est inférieure à un deuxième seuil prédéfini (S2), ouvrir le contacteur principal (4) pour activer la précharge (E6),
ladite précharge étant maintenue jusqu'à ce que la tension aval (V2) soit supérieure à un troisième seuil prédéfini (S3) et que la différence de tension (D) entre l'amont (V1) et l'aval (V2) du contacteur principal (4) soit inférieure au premier seuil prédéfini (S1), puis le contacteur principal (4) est fermé et le contacteur auxiliaire (7) est ouvert pour désactiver la précharge (E7).

2. Procédé selon la revendication 1, dans lequel :
- le premier seuil prédéfini (S1) correspond à la différence de tension maximale admissible entre l'amont (V1) et l'aval (V2) du contacteur principal (4), au-dessus de laquelle, lorsque le contacteur principal (4) est à l'état ouvert, la précharge est activée,
- le deuxième seuil prédéfini (S2) correspond au seuil de stabilisation de la tension aval (V2) du contacteur principal (4), au-dessus de laquelle, lorsque le contacteur principal (4) est ouvert, la précharge est désactivée,
- le troisième seuil prédéfini (S3) correspond à la tension nominale de fonctionnement de ladite charge (5), au-dessus de laquelle la différence de tension (D) entre l'amont (V1) et l'aval (V2) du contacteur principal (4) est comparée au premier seuil prédéfini (S1) pour maintenir ou désactiver la précharge.

3. Procédé selon l'une des revendications 1 ou 2, dans lequel la précharge correspond à une précharge électronique réalisée par des composants électroniques configurés pour moduler la résistance de limitation (9).

4. Procédé selon l'une des revendications 1 à 3, dans lequel le circuit de commutation (2) comprend un contacteur principal (4) bipolaire,
ledit procédé de précharge comprenant en outre les étapes suivantes :
- commander l'ouverture et la fermeture du contacteur principal (4) bipolaire de manière synchrone,
- réaliser la précharge sur l'au moins un pôle du contacteur principal (4) bipolaire associé à une branche auxiliaire (6a, 6b) comprenant une résistance de limitation (9).

5. Dispositif de précharge (10) dans un circuit de commutation (2) à haute tension comprenant au moins un contacteur principal (4), unipolaire ou bipolaire, connecté à au moins une source de tension (3), au moins une branche auxiliaire (6) comprenant un contacteur auxiliaire (7), ladite branche auxiliaire (6) étant montée en parallèle du contacteur principal (4), chaque pôle du contacteur principal (4) étant associé à une branche auxiliaire (6), au moins une desdites branches auxiliaires (6) comprenant une résistance de limitation (9) en série avec le contacteur auxiliaire (7), et au moins une charge (5) comprenant un élément capacitif et connectée en aval du contacteur principal (4),
le dispositif comprenant :
- un module de gestion (11) de la précharge, comprenant au moins une unité de traitement configurée pour mettre en œuvre les étapes du procédé de précharge selon l'une quelconque des revendications 1 à 4,
- un module de mesure de tension (12) configuré pour mesurer localement les tensions en amont (V1) et en aval (V2) du contacteur principal (4) et transmettre les valeurs mesurées à un module de comparaison (13),
- un module de comparaison (13), configuré pour comparer la différence de tension (D) entre l'amont (V1) et l'aval (V2) du contacteur principal (4) avec des seuils de tension prédéfinis (S1, S2, S3), et pour transmettre le résultat à un module de commande (14),
- un module de commande (14), configuré pour recevoir les données issues du module de comparaison (13) et pour commander l'ouverture ou la fermeture des contacteurs principal (4) et auxiliaire (7) en fonction des seuils de tension prédéfinis (S1, S2, S3), afin d'activer ou de désactiver une précharge.

6. Dispositif selon la revendication 5, dans lequel le module de gestion de la précharge (11) est configuré pour exécuter une précharge électronique, ladite précharge électronique étant réalisée par des composants électroniques configurés pour moduler la résistance de limitation et limiter le courant en fonction des variations de la différence de tension (D) entre l'amont (V1) et l'aval (V2) du contacteur principal (4).

7. Aéronef (1) **caractérisé en ce qu'**il comprend un dispositif de précharge (10) dans un circuit de commutation (2) selon l'une quelconque des revendications 5 ou 6.
